(19) Europäisches Patentamt
European Patent Office
Office européen des brevets

(11) **EP 1 987 367 B1**

(12) **EUROPÄISCHE PATENTSCHRIFT**

(45) Veröffentlichungstag und Bekanntmachung des Hinweises auf die Patenterteilung:
**18.05.2011 Patentblatt 2011/20**

(21) Anmeldenummer: **07822523.2**

(22) Anmeldetag: **13.11.2007**

(51) Int Cl.:
*G01R 31/312* (2006.01)   *G09G 3/00* (2006.01)

(86) Internationale Anmeldenummer:
**PCT/EP2007/062249**

(87) Internationale Veröffentlichungsnummer:
**WO 2008/058949 (22.05.2008 Gazette 2008/21)**

(54) **SENSORELEMENT, VORRICHTUNG UND VERFAHREN ZUR INSPEKTION EINER LEITERBAHNSTRUKTUR, HERSTELLUNGSVERFAHREN FÜR SENSORELEMENT**

SENSOR ELEMENT, DEVICE AND METHOD FOR INSPECTING A PRINTED CONDUCTOR STRUCTURE, PRODUCTION METHOD FOR SENSOR ELEMENT

ÉLÉMENT DE DÉTECTION, DISPOSITIF ET PROCÉDÉ POUR INSPECTER UNE STRUCTURE À PISTES CONDUCTRICES ET PROCÉDÉ DE PRODUCTION DUDIT ÉLÉMENT DE DÉTECTION

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **16.11.2006 DE 102006054089**

(43) Veröffentlichungstag der Anmeldung:
**05.11.2008 Patentblatt 2008/45**

(73) Patentinhaber: **SIEMENS AKTIENGESELLSCHAFT**
**80333 München (DE)**

(72) Erfinder:
• **KLAUSMANN, Hagen**
**91336 Heroldsbach (DE)**
• **KRAGLER, Karl**
**85622 Weissenfeld (DE)**

(56) Entgegenhaltungen:
**FR-A- 2 792 076      US-A- 4 961 052**
**US-A1- 2001 028 256      US-A1- 2006 097 744**
**US-A1- 2006 192 575**

**EP 1 987 367 B1**

## Beschreibung

Die vorliegende Erfindung betrifft ein Sensorelement, eine Vorrichtung sowie ein Verfahren zur Inspektion von einer an einem flächigen Träger ausgebildeten Leiterbahnstruktur, insbesondere zur kontaktlosen Inspektion von einer an einem Flachbildschirm-Substrat ausgebildeten Leiterbahnmatrix. Die vorliegende Erfindung betrifft ferner ein Herstellungsverfahren für das oben genannte Sensorelement.

Im Bereich der Fertigung von Flüssigkristallanzeigen (LCD, Liquid Crystal Display) ist für einen effektiven und wirtschaftlichen Fertigungsprozess eine Inspektion von elektrischen TFT-Elektroden (Thin Film Transistor-Elektroden) auf einem Glassubstrat erforderlich, um ggf. vorhandene Defekte möglichst frühzeitig im Verlauf eines Herstellungsprozesses für Flüssigkristallanzeigen zu erkennen.

Aus der US 5,974,869 ist ein Inspektionsverfahren für Wafer bekannt, wobei mit einer Metallspitze die Oberfläche von Wafern kontaktlos abgetastet wird. Dabei wird die Potentialdifferenz zwischen Metallspitze und Wafer-Oberfläche gemessen, wobei zu dieser Potentialdifferenz auch die Austrittsarbeit der Elektronen aus unterschiedlichen Materialen beträgt. Dadurch können außer unterschiedlichen Materialien auch chemische Veränderungen wie beispielsweise eine Korrosion oder geometrische Veränderungen einer Oberfläche wie beispielsweise eine Grabenstruktur erfasst werden. Das Inspektionsverfahren hat jedoch den Nachteil, dass die zu untersuchende Oberfläche relativ zu der Metallspitze rotiert werden muss, so dass das Inspektionsverfahren für Leiterbahnstrukturen, die auf flächigen Trägern ausgebildet sind, nicht geeignet ist.

Aus den US2001/0028256 und FR2 792 076 sind kontaktlose Inspektionsverfahren bekannt.

Um nun eine komplexe Leiterbahnmatrix, d.h. eine Matrix mit einer großen Anzahl von Pixeln in akzeptabler Zeit zu inspizieren, ist ein hohes Maß an Parallelität erforderlich. Dies bedeutet, dass mit einem Messkopf, welcher eine Mehrzahl von Sensorelektroden aufweist, gleichzeitig mehrere Messpunkte auf der Leiterbahnmatrix abgetastet bzw. inspiziert werden.

So sind beispielsweise auf einem modernen 20-Zoll-Computerbildschirm mit einer Auflösung von 1600 x 1200 Bildpunkten 5,76 Mio Pixel vorhanden. Dabei werden pro Bildpunkt drei Subpixel benötigt, um in bekannter Weise durch Farbmischung eine farbige Anzeige zu ermöglichen. Die Pixel haben dabei typischerweise Abstände von ungefähr $50\mu m$ (Handy- bzw. Kame-radisplays) bis hin zu 500 $\mu m$ (large scale LCD-TV).

Bei der Parallelisierung der Leitebahninspektion ist aufgrund der starken Abstandsabhängigkeit insbesondere von kapazitiven Messverfahren darauf zu achten, dass die verwendeten einzelnen Sensorelektroden geometrisch innerhalb von wenigen $\mu m$ in einer planen Ebene liegen. Ist diese Bedingung erfüllt, dann kann ein Mehrkanalsensor in Abständen von einigen $10\mu m$ über eine zu inspizierende TFT Leiterbahnmatrix geführt werden.

Der Erfindung liegt die Aufgabe zugrunde, ein Sensorelement und eine Vorrichtung zur Inspektion von einer an einem flächigen Träger ausgebildeten Leiterbahnstruktur anzugeben, welche auf vergleichsweise einfache Weise hergestellt werden können und welche eine präzise mehrkanalige Messung mit in einer Ebene angeordneten Sensorelektroden ermöglichen. Der Erfindung liegt ferner die Aufgabe zugrunde, ein Messverfahren zur Inspektion von einer an einem flächigen Träger ausgebildeten Leiterbahnstruktur anzugeben, mit dem auch komplexe Leiterbahnstrukturen für Flüssigkristallanzeigen mit einer großen Pixel-Anzahl in einer akzeptablen Zeit inspiziert werden können. Außerdem liegt der Erfindung die Aufgabe zugrunde, ein besonders vorteilhaftes Herstellungsverfahren für zumindest ein genanntes Sensorelement anzugeben.

Diese Aufgaben werden gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Sensorelement zur Inspektion von einer an einem flächigen Träger ausgebildeten Leiterbahnstruktur beschrieben. Das beschriebene Sensorelement eignet sich insbesondere zur kontaktlosen Inspektion von einer an einem Flachbildschirm-Substrat ausgebildeten Leiterbahnmatrix. Das Sensorelement weist auf (a) ein Substrat, welches mechanisch derart strukturiert ist, dass es einen erhabenen oberen Bereich und einen vertieften unteren Bereich aufweist, wobei der plane obere Bereich und der vertiefte untere Bereich durch einen Übergangsbereich miteinander verbunden sind, (b) eine Mehrzahl von Sensorelektroden, die an dem planen oberen Bereich ausgebildet sind, und (c) eine Mehrzahl von Verbindungsleitungen zum elektrischen Kontaktieren der Mehrzahl von Sensorelektroden. Dabei ist jeder Sensorelektrode eine Verbindungsleitung zugeordnet, welche sich von der jeweiligen Sensorelektrode bis hin zu dem vertieften unteren Bereich erstreckt.

Dem genannten Sensorelement liegt die Erkenntnis zugrunde, dass bei Verwendung eines stufenartig ausgebildeten Substrates Verdrahtungen, die zur elektrischen Kontaktierung der einzelnen Sensorelektroden erforderlich sind, auf Platz sparende Weise von dem oberen Bereich, welcher die Sensorelektroden umfasst, in dem unteren Bereich geführt werden können. Somit kann ein kompaktes mehrkanaliges Sensorelement realisiert werden, wobei jede Sensorelektrode einen separaten Messkanal definiert. Bevorzugt werden 2 hoch n Sensorelemente verwendet, wobei n eine ganze Zahl ist. Somit kann auf Platz sparende Weise beispielsweise ein 2-, 4-, 8-, 16-, 32-, 64-, 128-, 256-, 512-, 1028-kanaliges Sensorelement realisiert werden.

Die durch die Stufenanordnung des Substrates realisierte individuelle Kontaktierung aller Sensorelektroden ermöglicht eine individuelle Ansteuerung von einzelnen Sensorelektroden. Somit ist das beschriebene Sensorelement auf vielfältige Weisen einsetzbar, da eine Messung mit lediglich einer, mit mehreren oder mit allen an dem planen Bereich ausgebildeten Sensorelektroden möglich ist.

Das beschriebene Sensorelement eignet sich insbesondere zur Inspektion von halbfertigen Flachbildschirmsubstraten, die in einer Leiterbahn-Matrix eine Vielzahl von Dünnschicht-Transistoren aufweisen. Die Inspektion kann dabei durch ein Inspektionsverfahren durchgeführt werden, bei dem (a) mittels einer Positioniereinrichtung das Sensorelement und damit die Sensorelektroden relativ zu der Leiterbahnstruktur in einem vorbestimmten Abstand positioniert wird, (b) zwischen den Sensorelektroden und der Leiterbahnstruktur eine elektrische Spannung angelegt wird, (c) die Sensorelektroden durch eine entsprechende Ansteuerung der Positioniereinrichtung relativ zu dem Flachbildschirmsubstrat in einer Ebene parallel zu dem Flachbildschirmsubstrat bewegt werden, (d) ein Stromfluss durch zumindest eine mit einer Sensorelektrode verbundene elektrische Leitung gemessen wird, und (e) aus der Stärke des Stromflusses der lokale Spannungszustand der Leiterbahnstruktur in dem Teilbereich detektiert wird.

Gemäß einem Ausführungsbeispiel der Erfindung nach Anspruch 2 weist der erhabene obere Bereich eine planare Oberfläche auf. Dies hat den Vorteil, dass, eine identische Form aller Sensorelektroden vorausgesetzt, sich die Spitzen aller Sensorelektroden quasi automatisch innerhalb einer Ebene befinden. Bei einer parallelen Orientierung des Sensorelements zu der zu inspizierenden Leiterbahnstruktur können somit gleichzeitig eine Vielzahl von Messpunkten abgetastet werden, wobei für jede Sensorelektrode der selbe Messabstand zwischen Leiterbahnstruktur und Elektrodenspitze gegeben ist.

Unter dem Begriff planar ist im Folgenden eine Ebenheit zu verstehen, bei welcher der obere Bereich Höhen- bzw. Dickenschwankungen von maximal $\pm 2\,\mu$m, bevorzugt von maximal $\pm 1\,\mu$m und insbesondere von maximal $\pm 0,5$ $\mu$m aufweist. Selbstverständlich hängt die erforderliche Planarität von der jeweiligen Messaufgabe und insbesondere von der erforderlichen Genauigkeit bzw. Empfindlichkeit der Messsignale ab.

Gemäß einem weiteren Ausführungsbeispiel der Erfindung nach Anspruch 3 sind die Sensorelektroden und/ oder die Verbindungsleitungen mittels Dünnschicht- und/oder Mikrostrukturierungstechnik hergestellt. Dies hat den Vorteil, dass die einzelnen Sensorelektroden gemeinsam mittels beispielsweise aus der Halbleitertechnik bekannten Verfahrensschritten hergestellt werden können, die eine einheitliche und präzise Ausformung der einzelnen Sensorelektroden ermöglichen. Unter dem Begriff Mikrostrukturierungstechnik werden dabei beispielsweise mikrolithographische Verfahren verstanden, die insbesondere auf dem Gebiet der Herstellung von Halbleiterbauelementen oder von mikromechanischen Bauelementen verwendet werden. Durch die Verwendung von mikrolithographischen Verfahren kann eine Vielzahl von unterschiedlichen Sensorelementen reproduzierbar und mit gleich bleibender hoher Präzision hergestellt werden.

Bevorzugt werden die Sensorelektroden und/oder die Verbindungsleitungen auf einem mechanisch vorstrukturierten Substrat ausgebildet, bei dem der vertiefte untere Bereich beispielsweise durch Schleifen oder durch Heißverformen ausgebildet wurde. Damit kann der erhabene obere Bereich des Substrates im wesentlichen unbehandelt bleiben, so dass bei einer entsprechend hohen ursprünglichen Oberflächengüte des Substrates automatisch eine hohe Planarität des oberen Bereiches bzw. der einzelnen Sensorelektroden gewährleistet ist.

Gemäß Anspruch 4 weist das Sensorelement zusätzlich eine Abschirmung auf, welche derart ausgebildet ist, dass eine elektromagnetische Abstrahlung von den Verbindungsleitungen und/oder eine elektromagnetische Einstrahlung in die Verbindungsleitungen zumindest reduziert ist. Bevorzugt weist die Abschirmung eine metallische Schicht auf, die ebenfalls mittels Dünnfilmtechnik an dem beschriebenen Sensorelement aufgebracht werden kann.

Gemäß Anspruch 5 ist das Substrat ein Dünnglas. Die Verwendung von Dünnglas hat den Vorteil, dass eine Vorstrukturierung des stufenartigen Sensorelements auf einfache Weise beispielsweise mittels bekannter Präzisionsschleifprozesse erfolgen kann. Als besonders geeignet für das mit dieser Anmeldung beschriebene Sensorelement hat sich Borosilikatglas der Schott AG, Hattenbergstr. 10, D-55122 Mainz heraus gestellt. Die Verwendung von Dünnglas als Ausgangsmaterial hat ferner den Vorteil, dass auf einfache Weise eine besonders hohe Planarität mit Höhen- bzw. Dickenschwankungen von maximal +- 0,5 $\mu$m realisiert werden kann.

Gemäß Anspruch 6 ist das Substrat ein Wafer, insbesondere eine Silizium Wafer. Dies hat den Vorteil, dass zur Herstellung des beschriebenen Sensorelements ein aus der Halbleitertechnik genau bekanntes Substratmaterial verwendet wird, für dessen Handhabung und Bearbeitung eine Vielzahl von geeigneten Prozeduren bekannt sind. Zur Herstellung einer entsprechenden Vorstrukturierung, die zumindest eine Stufe bzw. zumindest eine Vertiefung aufweist, sind insbesondere nasschemische Ätzverfahren geeignet. Trockenätzverfahren können jedoch auch verwendet werden.

Gemäß Anspruch 7 weist das Sensorelement zusätzlich eine Mehrzahl von elektrischen Anschlussflächen zur weiteren Kontaktierung des Sensorelements auf, welche Anschlussflächen an dem vertieften unteren Bereich ausgebildet sind, wobei jeweils eine Anschlussfläche einer Sensorelektrode zugeordnet und mit der entsprechenden Verbindungsleitung elektrisch verbunden ist.

Bevorzugt sind die Anschlussflächen geeignet um sog. Bond-Verbindungen auszubilden. Dies hat den Vorteil, dass die einzelnen Sensorelektroden auf effektive Weise beispielsweise mittels eines ACF-Bondprozesses (Anisotropic Conductive Film-Bondprozesses) mit einer flexiblen Leiterplatine kontaktiert werden können. Dabei können alle Bond-Verbindungen einschließlich der flexiblen Leiterplatine so flach realisiert sein, dass selbst bei einer lediglich sehr geringen Vertiefung des unteren Bereiches im Vergleich zu dem oberen Bereich von beispielsweise 200 μm die flexible Leiter-platine nicht über die Sensorelektroden hinausragt, so dass die, Spitzen der Sensorelektroden die am meisten erhabenen Bereiche des beschriebenen Sensorelements darstellen.

Anstelle von flächigen Bond-Verbindungstechniken kann auch das sog. Wire-Bonding zur weiteren Kontaktierung des Sensorelements verwendet werden. Da auch das Wire-Bonding beispielsweise aus der IC-Verbindungstechnik gut bekannt ist, kann zur Herstellung des beschriebenen Sensorelements auf vorteilhafte Weise auf bekannte Verfahren zur elektrischen Kontaktierung zurückgegriffen werden.

Gemäß Anspruch 8 weist das Sensorelement zusätzlich eine flexible Leiterplatine auf, welche eine Mehrzahl von Ansteuerleitungen umfasst, wobei jeweils eine Ansteuerleitung mit einer elektrischen Anschlussfläche verbunden ist. Die Verwendung sog. Flexwire hat den Vorteil, dass das beschriebene Sensorelement auf einfache und zugleich zuverlässige Art und Weise kontaktiert werden kann. Außerdem kann das Sensorelement in verschiedene Messvorrichtungen eingebaut werden, welche ggf. für unterschiedliche Messaufgaben optimiert sind. Somit ist das beschriebene Sensorelement universal einsetzbar.

Gemäß Anspruch 9 weist die flexible Leiterplatine zumindest eine flächige Schirmung auf, so dass eine Abschirmung der Verbindungsleitungen an der flexiblen Leiterplatte bzw. an dem Flexwire weitergeführt werden kann.

Gemäß Anspruch 10 erfolgt der Übergang zwischen dem Übergangsbereich und dem erhabenen oberen Bereich und/oder der Übergang zwischen dem Übergangsbereich und dem vertieften unteren Bereich in einem flachen Winkel. In diesem Zusammenhang bedeutet der Ausdruck "flach", dass der entsprechende Übergangswinkel kleiner als 90° ist. Dies hat den Vorteil, dass das Aufbringen der Verbindungsleitungen erleichtert ist, da die Verbindungsleitungen nicht um eine scharfe Ecke herum angeformt werden müssen. Der Übergangswinkel ist bevorzugt erheblich kleiner als 90°, beispielsweise 5°.

An dieser Stelle wird darauf hingewiesen, dass der Übergang auch frei von Kanten, beispielsweise mit abgerundeten quasi kontinuierlichen Übergängen erfolgen kann.

Gemäß Anspruch 11 sind die Sensorelektroden in einer Reihe angeordnet. Dies hat neben einer besonders einfachen Realisierung den Vorteil, dass das beschriebene Sensorelement eine lineare Sensorzeile darstellt, in der die einzelnen Sensorelektroden bevorzugt äquidistant voneinander beabstandet sind. Durch eine lineare Bewegung des Sensorelements relativ zu einem zu inspizierenden Substrat kann somit eine Messfläche abgetastet werden, die von der Breite bzw. bei gegebenem Sensorelektroden-Abstand von der Anzahl der Sensorelektroden abhängt.

An dieser Stelle wird darauf hingewiesen, dass die Sensorelektroden auch gegeneinander versetzt in zumindest zwei Reihen angeordnet sein können. Dies hat den Vorteil, dass das beschriebene Sensorelement an verschiedene Messaufgaben angepasst werden kann. Insbesondere ist eine Anpassung an unterschiedliche Teilungsabstände (sog. Pitch-Abstände) von Dünnschicht-Transistoren möglich, welche auf Substraten von Flüssigkristall-Flachbildschirmen ausgebildet bzw. angeordnet sein können.

Mit dem unabhängigen Patentanspruch 12 wird eine Vorrichtung zur Inspektion von einer an einem flächigen Träger ausgebildeten Leiterbahnstruktur beschrieben. Die beschriebene Vorrichtung eignet sich insbesondere zur kontaktlosen Inspektion von einer an einem Flachbildschirm-Substrat ausgebildeten Leiterbahnmatrix. Die Vorrichtung weist auf (a) ein Chassis, (b) ein Aufnahmeelement, welches an dem Chassis angeordnet ist und welches zur Aufnahme des flächigen Trägers eingerichtet ist, (c) zumindest ein Sensorelement nach einer der oben beschriebenen Ausführungsformen zur Inspektion der Leiterbahnstruktur und (d) ein Positioniersystem, welches an dem Chassis angeordnet ist und welches derart mit dem Sensorelement und/oder mit dem Aufnahmeelement gekoppelt ist, dass das Sensorelement relativ zu dem flächigen Träger in einer Ebene parallel zu der Leiterbahnstruktur positionierbar ist.

Der genannten Inspektionsvorrichtung liegt die Erkenntnis zugrunde, dass das oben beschriebene Sensorelement mittels einer herkömmlichen Präzisions-Positioniereinrichtung relativ zu einer zu inspizierenden Leiterbahnstruktur bewegt werden kann und so auf einfache Weise eine flächige Abtastung der Leiterbahnstruktur realisiert werden kann. Derartige Präzisions-Positioniereinrichtungen sind insbesondere aus dem Bereich der Elektronikfertigung bekannt, so dass zur Realisierung der Inspektionsvorrichtung auf bekannte Standartkomponenten zurückgegriffen werden kann. Die genannte Inspektionsvorrichtung kann somit vergleichsweise kostengünstig hergestellt werden.

Das Positioniersystem kann ein so genanntes Flächenpositioniersystem sein, welches eine zweidimensionale Bewegung des Sensorelements relativ zu dem flächigen Träger ermöglicht.

Dabei kann sowohl eine zweidimensionale Positionierung des Trägers als auch eine zweidimensionale Positionierung des Sensorelements erfolgen.

Das Positioniersystem kann auch derart ausgestaltet sein, dass der Träger entlang einer ersten Richtung und das Sensorelement entlang einer zweiten Richtung bewegbar ist, welche zweite Richtung winklig, bevorzugt senkrecht, zu der ersten Richtung orientiert ist. Auf diese Weise kann durch eine Kombination zweier linearer Bewegungen eine präzise vollständige Abtastung einer zweidimensionalen Leiterbahnstruktur realisiert werden. Dies gilt auch dann, wenn die Fläche der Leiterbahnstruktur so groß ist, dass durch eine lediglich eindimensionale Bewegung des Sensorelements entlang einer Richtung, welche Richtung bevorzugt senkrecht zu einer durch nebeneinander angeordnete Sensorelektroden definieren Sensorzeile orientiert ist, eine vollständige Abtastung nicht möglich ist.

Selbstverständlich kann auch lediglich eine eindimensionale Positionierung des Sensorelements relativ zu dem Träger erfolgen. Auch in diesem Fall kann eine flächige Abtastung der Leiterbahnstruktur realisiert werden, wenn ein Sensorelement mit einer länglichen Messzeile verwendet wird oder wenn gleichzeitig mehrere Sensorelemente verwendet werden.

Gemäß einem Ausführungsbeispiel der Erfindung nach Anspruch 13 weist die Vorrichtung zusätzlich eine Auswerteeinheit auf, welche dem Sensorelement nachgeschaltet ist und welche zur Auswertung der von dem Sensorelement bereitgestellten Messsignale eingerichtet ist.

Die Auswerteeinheit ist beispielsweise eingerichtet, den lokalen Spannungszustand eines Teilbereichs der Leiterbahnstruktur zur Bestimmung der Qualität derselben auszuwerten. Unter dem Begriff Qualität der Leiterbahnstruktur sind in diesem Zusammenhang insbesondere die flächigen geometrischen Abmessungen der Leiterbahnstruktur zu verstehen. Dazu zählen insbesondere Defekte wie Kurzschlüsse, Einschnürungen oder Leitungsbrüche. Derartige Defekte ändern auf jeden Fall die örtliche Spannungsverteilung und können somit zuverlässig erkannt werden.

Die Qualität der Leiterbahnstruktur wird jedoch auch durch dielektrische Einflüsse bestimmt, welche die Kapazität zwischen der jeweiligen Sensorelektrode und der Leiterbahnstruktur beeinflussen. Dies geschieht beispielsweise durch chemische Veränderungen der Leiterbahnstruktur oder durch unerwünschte dielektrische Ablagerungen auf der Leiterbahnstruktur.

Mit dem unabhängigen Anspruch 14 wird ein Verfahren zur Inspektion von einer an einem flächigen Träger ausgebildeten Leiterbahnstruktur beschrieben. Das beschriebene Verfahren eignet sich insbesondere zur kontaktlosen Inspektion von einer an einem Flachbildschirm-Substrat ausgebildeten Leiterbahnmatrix. Das Verfahren weist die folgenden Schritte auf: (a) Positionieren des Sensorelements gemäß einer oben beschriebenen Ausführungsform mittels eines Positioniersystems relativ zu der Leiterbahnstruktur in einem vorbestimmten Messabstand, (b) Anlegen einer elektrischen Spannung zwischen den Sensorelektroden und der Leiterbahnstruktur, (c) Bewegen des Sensorelements durch eine entsprechende Ansteuerung des Positioniersystems relativ zu dem flächigen Träger in einer Ebene parallel zu der Leiterbahnstruktur, (d) Messen eines Stromflusses durch zumindest eine mit einer Sensorelektrode verbundene Verbindungsleitung und (e) Detektieren eines lokalen Spannungszustands in zumindest einem Teilbereich der Leiterbahnstruktur.

Dem beschriebenen Verfahren liegt die Erkenntnis zugrunde, dass die Verteilung und der Verlauf der elektrischen Feldlinien zwischen den einzelnen Sensorelektroden und den jeweiligen Abtast-Teilbereichen der Leiterbahnstruktur von dem lokalen Spannungszustand abhängen. Der Verlauf der elektrischen Feldlinien bestimmt dabei die elektrische Kapazität zwischen der Sensorelektrode und dem Abtast-Teilbereich. Mit einer Variation der Feldlinienverteilung ändert sich somit auch die Kapazität zwischen Sensorelektrode und dem Abtast-Teilbereich der Leiterbahnstruktur, so dass sich der Stromfluss I zwischen der jeweiligen Sensorelektrode und der Leiterbahnstruktur aus folgender Gleichung ergibt:

$$I = (U_{AC} + U_{DC})\ dC/dt + C\ dU_{AC}/dt$$

Dabei ist $U_{AC}$ eine Wechselspannung und $U_{DC}$ eine Gleichspannung, die zwischen der jeweiligen Sensorelektrode und der Leiterbahnstruktur anliegen. C ist die Kapazität zwischen Sensorelektrode und Leiterbahnstruktur. Der Ausdruck d/dt bezeichnet die zeitliche Ableitung der Größen C bzw. $U_{AC}$. Der Stromfluss I fließt dabei auch durch die der jeweiligen Sensorelektrode zugeordnete Verbindungsleitung und kann durch entsprechend empfindliche Strommesseinrichtungen detektiert werden.

Es wird darauf hingewiesen, dass für die Realisierung der Erfindung lediglich eine relative Positionierung zwischen Leiterbahn und Sensorelement erforderlich ist. Dies bedeutet, dass entweder das Sensorelement, der flächige Träger oder auch das Sensorelement und der Träger mittels zumindest einem Positioniersystem bewegt werden kann.

Das beschriebene Verfahren hat den Vorteil, dass der lokale Spannungszustand der Leiterbahnstruktur im Vergleich zu bekannten Inspektionsverfahren mit einer einfachen und vergleichsweise billigen Erfassungselektronik gemessen werden kann. Damit kann das kontaktlose Inspektionsverfahren mit einer Vorrichtung durchgeführt werden, welche elektrische und mechanische Komponenten enthält, die von vielen verschiedenen Herstellern angeboten werden und deshalb vergleichsweise gleich günstig erworben werden können.

Gemäß einem Ausführungsbeispiel der Erfindung nach Anspruch 15 wird die Leiterbahnstruktur durch eine rasterförmige Bewegung des Sensorelements abgetastet. Dies hat den Vorteil, dass eine matrixförmige Anordnung von Leiterbahnstrukturen im Rahmen eines standardisierten Abtastvorganges zügig vermessen werden kann. Dabei kann das Sensorelement beispielsweise in einer mäanderförmigen Bewegung über die zu inspizierende Leiterbahnstruktur geführt werden. Die Relativbewegung zwischen Sensorelement und Träger erfolgt bevorzugt kontinuierlich. Die Relativbewegung kann jedoch genauso gut in Form einer schrittweise durchgeführten Bewegung erfolgen.

Gemäß einem weiteren Ausführungsbeispiel der Erfindung nach Anspruch 16. wird zwischen den Sensorelektroden und der Leiterbahnstruktur eine amplitudenmodulierte Spannung angelegt. Dies ermöglicht eine besonders empfindliche Inspektion, so dass nahezu alle Defekte einer Leiterbahnstruktur zuverlässig erkannt werden können.

Mit dem unabhängigen Patentanspruch 17 wird ein Herstellverfahren für zumindest ein Sensorelement zur Inspektion von einer an einem flächigen Träger ausgebildeten Leiterbahnstruktur angegeben. Das Herstellverfahren weist die folgenden Schritte auf: (a) Erzeugen von zumindest einer Grabenstruktur in einem Ausgangssubstrat, so dass in dem Ausgangssubstrat ein erhabener oberer Flächenbereich und ein vertiefter unterer Flächenbereich entsteht, die über einen Übergangs-Zwischenbereich miteinander verbunden sind, (b) Ausbilden der Mehrzahl von Sensorelektroden an dem oberen Flächenbereich, (c) Ausbilden der Mehrzahl von Verbindungsleitungen, wobei jeder Sensorelektrode eine Verbindungsleitung zugeordnet ist, welche sich von der jeweiligen Sensorelektrode bis hin zu dem vertieften unteren Flächenbereich erstreckt, und (d) Vereinzeln des Ausgangssubstrates derart, dass zumindest ein Sensorelement nach einem oben beschriebenen Ausführungsbeispiele ausgeschnitten wird. Dabei ist der erhabene obere Bereich des Sensorelements dem erhabenen oberen Flächenbereich des Ausgangssubstrates zugeordnet. Ferner ist der vertiefte untere Bereich des Sensorelements dem vertieften unteren Flächenbereich des Ausgangssubstrates zugeordnet. Außerdem ist der Übergangsbereich des Sensorelements dem Übergangs-Zwischenbereich des Ausgangssubstrates zugeordnet.

Dem beschriebenen Herstellverfahren liegt die Erkenntnis zugrunde, dass gleichzeitig eine Mehrzahl der oben beschriebenen Sensorelemente durch eine gemeinsame Bearbeitung eines gemeinsamen Ausgangssubstrates hergestellt werden können, wobei nach einer entsprechenden Ausbildung sämtlicher Sensorelektroden und Verbindungsleitungen das Ausgangssubstrat in geeigneter Weise vereinzelt wird. Das Ausgangssubstrat kann ein Glassubstrat, beispielsweise ein Silikatglas, oder ein Wafer, beispielsweise aus Silizium, sein. Das Ausbilden der Sensorelektroden und Verbindungsleitungen erfolgt bevorzugt mittels bekannter lithographischer bzw. photolithographischer Verfahren.

Gemäß einem Ausführungsbeispiel der Erfindung nach Anspruch 18 weist das Herstellverfahren zusätzlich den folgenden Schritt auf: Ausbilden von lateralen Abschirmungen, die sich von dem erhabenen oberen Flächenbereich bis hin zum dem vertieften unteren Flächenbereich erstrecken, wobei jeweils eine laterale Abschirmung neben einer Verbindungsleitung angeordnet ist.

Bei einer entsprechenden Kontaktierung der lateralen Abschirmung, bevorzugt bei einer Erdung der lateralen Abschirmungen, kann somit während des Betriebes von entsprechend erzeugten Sensorelementen eine elektromagnetische Abstrahlung von den Verbindungsleitungen und/oder eine elektromagnetische Einstrahlung in die Verbindungsleitungen erheblich reduziert werden. Auf diese Weise kann die Empfindlichkeit und die Zuverlässigkeit der Sensorelemente erheblich erhöht werden.

Die lateralen Abschirmungen können durch eine dünne metallische Schicht, beispielsweise durch eine entsprechend strukturierte Aluminium Schicht realisiert werden. Als günstig haben sich Schichtdicken im Bereich von 200 bis 500nm erwiesen. Neben Aluminium können auch Legierungen des Aluminiums, beispielsweise mit Kupfer (AlCu), aber auch Chrom und Chrom-Legierungen verwendet werden.

Gemäß einem weiteren Ausführungsbeispiel der Erfindung nach Anspruch 19 weist das Herstellverfahren zusätzlich die folgenden Schritte auf: (a) Aufbringen einer ersten Metallisierungsschicht und Freilegen der Verbindungsleitungen, (b) Aufbringen einer Isolationsschicht, (c) Freilegen der Sensorelektroden und der lateralen Abschirmungen von der Isolationsschicht, (d) Aufbringen einer zweiten Metallisierungsschicht, so dass die lateralen Abschirmungen und die zweite Metallisierungsschicht elektrisch leitend miteinander verbunden sind, und (e) Freilegen der Sensorelektroden von der zweiten Metallisierungsschicht. Dies hat den Vorteil, dass mit der zweiten Metallisierungsschicht eine vollflächige Abschirmungselektrode erzeugt wird, welche die elektromagnetische Empfindlichkeit der mit dem beschriebenen Herstellungsverfahren erzeugten Sensorelemente weiter reduziert.

Die Isolationsschicht kann beispielsweise eine Siliziumnitridschicht sein. Auch hier hat sich eine Schichtdicke im Bereich von 200 bis 800nm als günstig erwiesen. Es sei darauf hingewiesen, dass die Isolationsschicht auch aus Siliziumdioxid oder auch Siliziumoxidnitrid bestehen kann. Das Freilegen der Sensorelektroden und der lateralen Abschirmungen erfolgt bevorzugt mittels einer geeigneten lithographischen Prozedur. Die erste und/oder die zweite Metallisierungsschicht kann beispielsweise erneut eine Aluminiumschicht im Bereich von 200 bis 500nm sein. Dies entspricht der oben genannten Schicht zur Herstellung der lateralen Abschirmungen. Auch hier sind andere Metallisierungen, wie AlCu oder Cr denkbar.

Es wird darauf hingewiesen, dass in entsprechender Weise auch vor dem Ausbilden der Verbindungsleitungen eine untere Metallisierungsschicht auf dem Ausgangssubstrat ausgebildet werden kann, wobei die untere Metallisierungsschicht mittels einer weiteren Isolationsschicht von den Verbindungsleitungen elektrisch getrennt ist. Somit kann durch eine geeignete Verbindung dieser unteren Metallisierungsschicht mit den lateralen Abschirmungen und der genannten oberen Metallisierungsschicht eine Abschirmungselektrode erzeugt wird, welche die Verbindungsleitungen vollständig umgibt. Dies trägt zu einer noch besseren Abschirmung der Verbindungsleitungen bei.

Gemäß Anspruch 20 weist das Herstellverfahren zusätzlich den folgenden Schritt auf: Kontaktieren der Verbindungsleitungen mittels einer flexiblen Leiterplatine. Dabei erfolgt das weitere Kontaktieren der Verbindungsleitungen bevorzugt nach dem Vereinzeln der einzelnen Sensorelemente aus dem gemeinsamen Ausgangssubstrat.

Die Kontaktierung mittels einer flexiblen Leiterplatine hat den Vorteil, dass jedes einzelne Sensorelement auf einfache und zugleich zuverlässige Art und Weise kontaktiert werden kann. Außerdem kann das Sensorelement in auf ggf. in Hinblick auf unterschiedliche Messaufgaben optimierte Messvorrichtungen eingebaut werden, so dass das beschriebene Sensorelement universal einsetzbar ist.

Die Kontaktierung der flexiblen Leiterplatine an die Verbindungsleitungen kann über eine Mehrzahl von elektrischen Anschlussflächen erfolgen, welche an dem unteren Bereich ausgebildet sind. Dabei ist jeweils eine Anschlussfläche einer Sensorelektrode zugeordnet und mit der entsprechenden Verbindungsleitung elektrisch verbunden. Die Ausbildung der Anschlussflächen kann in geeigneter Weise mit den oben beschriebenen Herstellungsschritten kombiniert werden.

Wie oben bereits erläutert, sind die Anschlussflächen zur Ausbildung von sog. Bond-Verbindungen geeignet. Dies hat den Vorteil, dass die einzelnen Sensorelektroden auf effektive Weise beispielsweise mittels eines flächigen Bondprozesses oder mittels Wire-Bonding mit einer flexiblen Leiterplatine kontaktiert werden können.

Gemäß Anspruch 21 sind eine Mehrzahl von herzustellenden Sensorelementen derart in dem Ausgangssubstrat platziert, dass (a) einige Sensorelemente zueinander benachbart in einer Reihe parallel zu einer Längsachse der Grabenstruktur angeordnet sind und/oder dass (b) einige Sensorelemente in Bezug auf eine Längsachse der Grabenstruktur einander gegenüberliegend an unterschiedlichen Seiten angeordnet sind.

Dies hat den Vorteil, dass die einzelnen Sensorelemente im Nutzen des Ausgangssubstrates auf effektive und Platz sparende Weise angeordnet sind. Jedes Sensorelement weist somit einen oberen Teil des erhabenen oberen Flächenbereichs des Ausgangssubstrates und einen unteren Teil des vertieften unteren Flächenbereiches des Ausgangssubstrates auf. Wie oben im Zusammenhang mit dem erfindungsgemäßen Sensorelement beschrieben, werden an dem oberen Teil die Sensorelektroden angeformt, wohingegen der untere Teil für eine Kontaktierung des jeweiligen Sensorelements dient.

Das beschriebene Herstellungsverfahren hat zudem den Vorteil, dass über das Layout und die Größe des Ausgangssubstrates eine große Anzahl von einzelnen Sensorelementen auf effektive Weise hergestellt werden kann.

Selbstverständlich können in einem Ausgangssubstrat auch mehrere Gräben ausgebildet werden, die bevorzugt parallel zueinander orientiert sind. Auf diese Weise kann ein flächiges Ausgangssubstrat nahezu vollständig zur Herstellung der erfindungsgemäßen Sensorelemente genutzt werden.

Weitere Vorteile und Merkmale der vorliegenden Erfindung ergeben sich aus der folgenden beispielhaften Beschreibung derzeit bevorzugter Ausführungsformen. In der Zeichnung zeigen in schematischen Darstellungen:

Figur 1      eine perspektivische Darstellung einer Inspektions- vorrichtung zur kontaktlosen Inspektion von einer an einem Flachbildschirm-Substrat ausgebildeten Leiter- bahnmatrix,

Figur 2a      eine Mehrkanal-Sensorelement in einer perspektivi- schen Darstellung,

Figur 2b      das in Figur 2a dargestellte Mehrkanal-Sensorelement in einer Draufsicht,

Figur 3a      ein vorstrukturiertes Ausgangssubstrat zur Herstel- lung einer Mehrzahl von Mehrkanal-Sensorelementen in einer Draufsicht,

Figur 3b      das in Figur 3a dargestellte Ausgangssubstrat in einer Querschnittsansicht,

Figur 3c      eine räumliche Anordnung einer Vielzahl von herzu- stellenden Mehrkanal-Sensorelementen auf dem in Figur 3a dargestellten Ausgangssubstrat,

Figur 4a      ein Zwischenprodukt bei der Herstellung eines Mehr- kanal-Sensorelementes in einer Draufsicht, wobei auf dem Sensorsubstrat mittels einer ersten Metallisie- rungsebene Sensorelektroden, Verbindungsleitungen, Anschlussflächen und Abschirmungen ausgebildet wur- den,

Figur 4b      das in Figur 4a dargestellte Zwischenprodukt in einer perspektivischen Darstellung,

Figur 4c      eine vergrößerte Darstellung der Sensorelektroden, der Verbindungsleitungen und einer Abschirmung des in Figur 4a dargestellten Zwischenprodukts,

Figur 5a      ein hergestelltes Mehrkanal-Sensorelement in einer Draufsicht,

Figur 5b      das in Figur 5a dargestellte Mehrkanal-Sensorelement in einer perspektivischen Darstellung,

Figur 6a    ein mit einer flexiblen Leiterplatine kontaktiertes Mehrkanal-Sensorelement in einer perspektivischen Darstellung und

Figur 6b    das in Figur 6a dargestellte Mehrkanal-Sensorelement in einer Querschnittsansicht.

An dieser Stelle bleibt anzumerken, dass sich in der Zeichnung die Bezugszeichen von gleichen oder von einander entsprechenden Komponenten lediglich in ihrer ersten Ziffer unterscheiden.

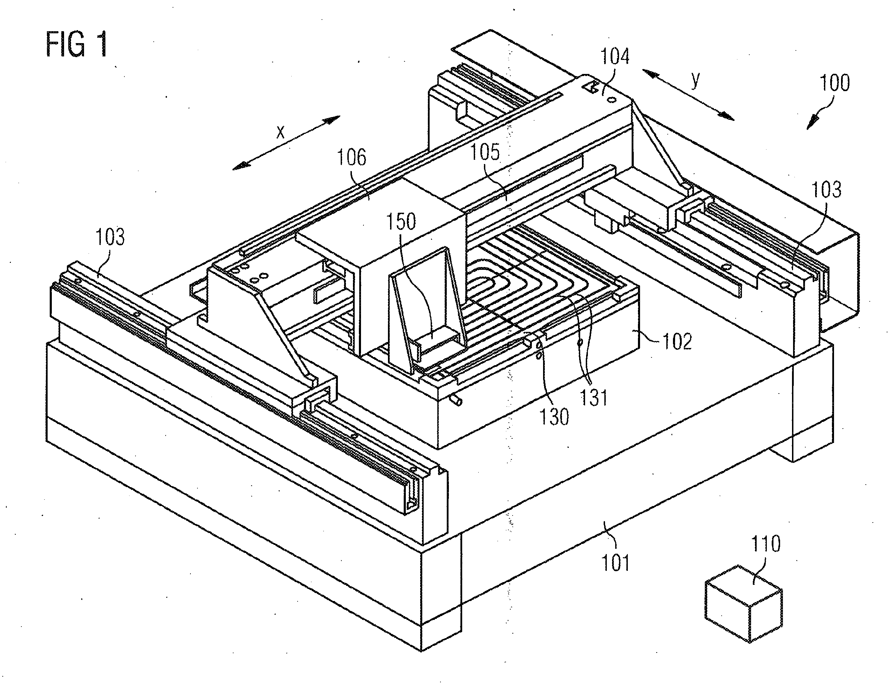

Figur 1 zeigt eine Inspektionsvorrichtung 100 zur kontaktlosen Inspektion von einer an einem flächigen Träger 130 ausgebildeten Leiterbahnstruktur 131. Gemäß dem hier dargestellten Ausführungsbeispiel ist der flächige Träger ein Flachbildschirm-Substrat 130, auf welchem nach einem frühen Herstellungsschritt für die Herstellung eines LCD-Flachbildschirms eine Leiterbahnmatrix 131 ausgebildet wurde, mittels welcher eine Vielzahl von Dünnschichttransistoren kontaktiert werden.

Die Inspektionsvorrichtung 100 weist einen Rahmen bzw. ein Chassis 101 auf, an welchem ein Aufnahmeelement 102 angeordnet ist. Das Aufnahmeelement 102, welches gemäß dem hier dargestellten Ausführungsbeispiel ein Fixiertisch 102 ist, dient der Aufnahme des Flachbildschirm-Substrats 130.

An dem Chassis 101 sind zwei parallel ausgerichtete Führungen 103 angebracht sind. Die beiden Führungen 103 tragen einen quer stehenden Trägerarm 104. Der quer stehende Trägerarm 104 weist eine Führung 105 auf, an welcher ein Trägerelement 106 verschiebbar gelagert ist. Die beiden Führungen 103 verlaufen entlang einer y-Richtung, die Führung 105 verläuft entlang einer x-Richtung.

An dem Trägerelement 106 ist ein Mehrkanal-Sensorelement 150 angeordnet, welches eine Mehrzahl von nicht dargestellten Sensorelektroden aufweist. Die Führungen 103, der Trägerarm 104, die Führung 105 und das Trägerelement 106 stellen zusammen nicht dargestellten Antriebsmotoren ein Flächen-Positioniersystem dar. Durch eine entsprechende Ansteuerung der Antriebsmotoren kann das Mehrkanal-Sensorelement 150 parallel zu dem Flachbildschirm-Substrat 130 positioniert werden. Dabei wird eine stets ein bestimmter vorgegebener Messabstand von einigen 10 $\mu$m zwischen den Sensorelektroden und der Leiterbahnmatrix eingehalten.

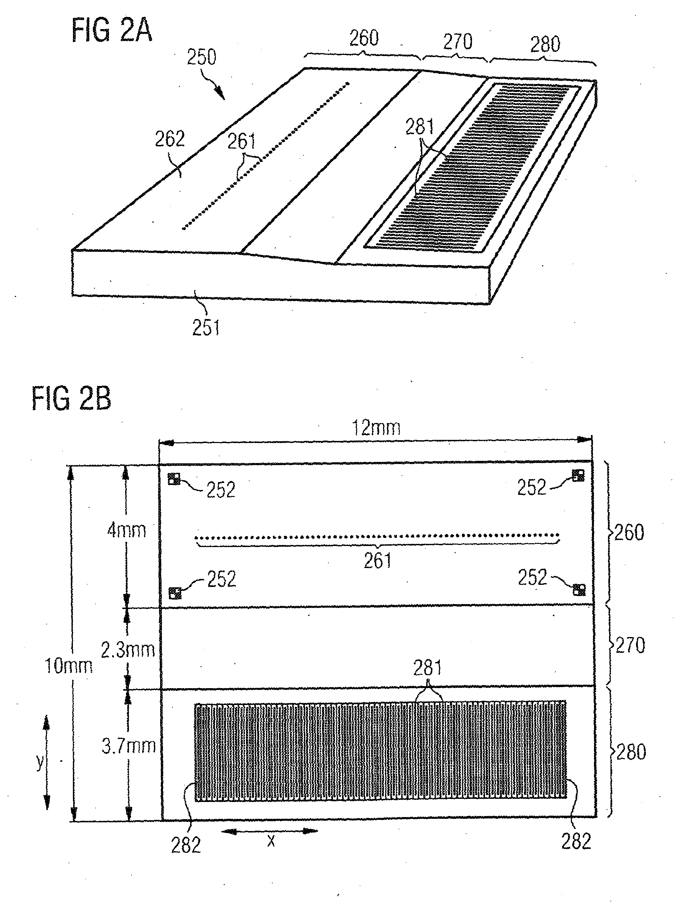

Figur 2a zeigt das für die Inspektionsvorrichtung 100 verwendete Mehrkanal-Sensorelement 150, welches nunmehr mit dem Bezugszeichen 250 versehen ist. Das Mehrkanal-Sensorelement 250 weist ein gestuftes Substrat 251 auf, welches beispielsweise ausgehend von einem Dünnglas oder einem Wafer vorstrukturiert wurde. Demzufolge weist das Sensorelement 250 einen erhabenen oberen Bereich 260 und einen vertieften unteren Bereich 280 auf, welche über einen stufenförmigen Übergangsbereich 270 miteinander verbunden sind.

Der erhabene obere Bereich 260 ist mit einer Mehrzahl von Sensorelektroden 261 versehen, die entlang einer Reihe angeordnet sind. Der erhabene obere Bereich 260 weist eine sehr hohe Planarität auf, wobei die Höhenschwankungen der Oberfläche 262 des Bereichs 260 lediglich eine Unebenheit von maximal $\pm\,0{,}5\,\mu$m erreichen. Dies bedeutet, dass sich, eine identische Form aller Sensorelektroden vorausgesetzt, die Spitzen aller Sensorelektroden 261 quasi automatisch innerhalb einer Ebene befinden.

Der vertiefte untere Bereich 280 ist mit einer Mehrzahl von Anschlussflächen 281 versehen. Jede Anschlussfläche 281 ist mittels einer von einer Deckschicht verdeckten und somit nicht dargestellten Verbindungsleitung mit einer der Sensorelektroden 261 verbunden.

Wie aus Figur 2a ersichtlich, weist die durch den Zwischenbereich 270 gebildete Stufe einen sehr flachen Winkel auf. Dieser Winkel beträgt gemäß dem hier dargestellten Ausführungsbeispiel ungefähr 5°. Dies hat den Vorteil, dass die Verbindungsleitungen, lediglich über einen weitgehend kantenfreien flachen Übergang geführt sind, so dass bei der Herstellung der Verbindungsleitungen, welche Herstellung bevorzugt mittels bekannter Lithographieverfahren erfolgen kann, Leitungsunterbrechungen kaum zu besorgen sind.

Figur 2b zeigt das Mehrkanal-Sensorelement 250 in einer Draufsicht. Gemäß dem hier dargestellten Ausführungsbeispiel weist das Mehrkanal-Sensorelement 250 insgesamt 64 Sensorelektroden 261 auf. Parallel zu der Reihe der Sensorelemente 261 weist das Sensorelement 250 entlang einer x-Richtung eine Länge von 12 mm auf. Das Sensorelement 250 weist ferner senkrecht zu der Reihe der Sensorelemente 261 entlang einer y-Richtung eine Breite von 10 mm auf, wobei der erhabene obere Bereich 260 eine Breite von 4 mm, der Zwischenbereich 270 eine Breite von 2,3 mm und der vertiefte untere Bereich 280 eine Breite von 3,7 mm aufweist. Selbstverständlich sind auch andere räumliche Abmessungen des Mehrkanal-Sensorelements 250 möglich.

In dem erhabenen oberen Bereich 260 sind ferner vier Zentriermarkierungen 252 vorhanden, welche bei der Herstellung des Mehrkanal-Sensorelements 250 von Bedeutung ist. Diese Herstellung wird weiter unten genauer beschrieben. Die Zentriermarkierungen 252 dienen dabei beispielsweise einer genauen räumlichen Zuordnung von Masken für Strukturierungsschritte bei der Herstellung von Sensorelektroden, Verbindungsleitungen und Anschlussflächen.

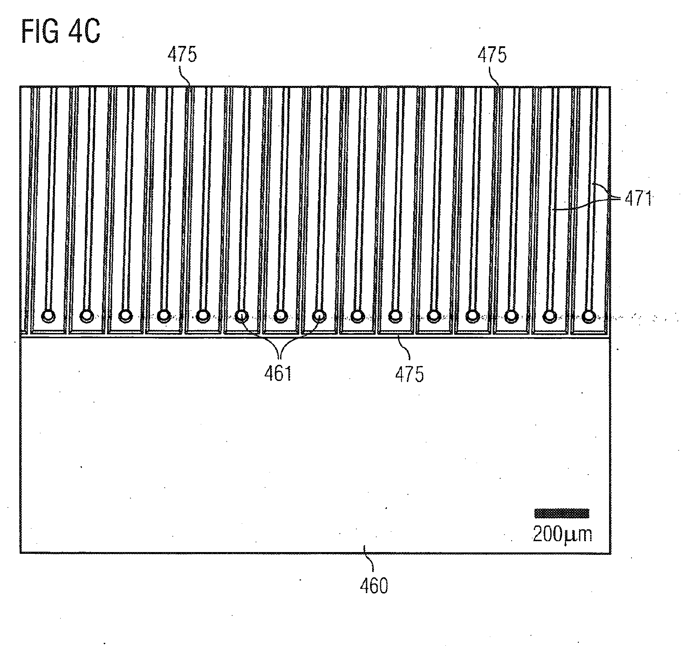

In dem vertieften unteren Bereich 280 sind 64 Anschlussflächen 281 ausgebildet. Jede Anschlussfläche 281 ist über eine nicht dargestellte Verbindungsleitung mit einer bestimmten Sensorelektrode 261 verbunden. Dabei sind die Verbindungsleitungen jeweils mit einer Abschirmung versehen, die gemeinsam über Erdungs-Anschlussflächen 282 kontaktiert werden können. Die genaue Form der Abschirmung wird nachfolgend anhand von Figur 4c im Detail erläutert.

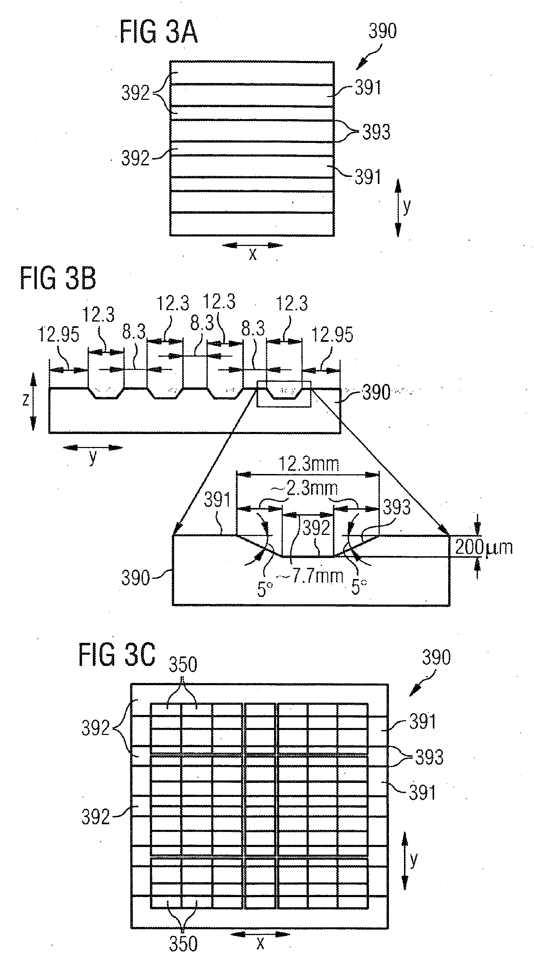

Im Folgenden wird ein bevorzugtes Herstellungsverfahren für ein bzw. für eine Mehrzahl von Mehrkanal-Sensorelemente anhand der Figuren 3 bis 6 beschrieben. Dabei werden weitere strukturelle Details des oben beschriebenen Mehrkanal-Sensorelements 250 erläutert.

Figur 3a zeigt in einer Draufsicht ein vorstrukturiertes Ausgangssubstrat 390 zur Herstellung einer Mehrzahl von Mehrkanal-Sensorelementen. Die Vorstrukturierung, welche mittels mechanischen Schleifens und/oder einem Ätzvorgang erfolgen kann, bildet in dem Ausgangssubstrat 390 eine Grabenstruktur 391 aus. Die Grabenstruktur weist mehrere voneinander beabstandet angeordnete vertiefte untere Flächenbereiche 391 auf. Die vertieften unteren Flächenbereiche 391 erstrecken sich entlang einer x-Richtung. Zwischen zwei benachbarten vertieften unteren Flächenbereichen 391 befindet sich jeweils ein erhabener oberer Flächenbereich 392. Ein vertiefter unterer Flächenbereich 391 geht senkrecht zu seiner Längserstreckung, d.h. entlang einer y-Richtung über einen Übergangs-Zwischenbereich 393 in einen erhabenen oberen Flächenbereich 392 über.

Gemäß dem hier dargestellten Ausführungsbeispiel verlaufen die vertieften unteren Flächenbereiche 391 bzw. die erhabenen oberen Flächenbereiche 392 parallel zueinander. Es sind jedoch auch andere Grabenstrukturen, beispielsweise eine mäanderförmige Grabenstruktur denkbar.

Figur 3b zeigt das Ausgangssubstrat 390 in einer Querschnittsansicht senkrecht zur x-Richtung. Die äußeren erhabenen oberen Flächenbereiche am Rand des Ausgangssubstrates 390 weisen entlang des y-Richtung eine Breite von ungefähr 13 mm auf. Die inneren erhabenen oberen Flächenbereiche weisen eine Breite von 8,3 mm auf. Die vertieften unteren Flächenbereiche 391 weisen ein Breite von 7,7 mm und die zwei jeweils benachbarten Übergangs-Zwischenbereiche 393 weisen eine Breite von ungefähr 2,3 mm auf. Die Übergangs-Zwischenbereiche 393 sind in einem Winkel von ca. 5° relativ zu der Oberfläche der erhabenen oberen Flächenbereiche 391 geneigt. Der Höhenunterschied entlang der z-Richtung zwischen den erhabenen oberen Flächenbereiche 391 und den vertieften unteren Flächenbereiche 391 beträgt ungefähr 200 $\mu$m. Selbstverständlich sind auch andere geometrische Abmessungen denkbar, um, wie in folgenden erläutert, einen Mehrkanal-Sensorelemente herzustellen.

Figur 3c zeigt die Anordnung einer Vielzahl von herzustellenden Mehrkanal-Sensorelementen 350 auf dem Ausgangssubstrat 390. Die einzelnen Sensorelemente 350 sind zueinander benachbart in mehreren Reihen parallel zur x-Richtung angeordnet. Ferner sind Sensorelemente 350, die zwei einander benachbarten Reihen zugeordnet sind, einander gegenüberliegend angeordnet. Jedes Sensorelement 350 weist somit einen oberen Teil des erhabenen oberen Flächenbereichs 392 des Ausgangssubstrates 390 und einen unteren Teil des vertieften unteren Flächenbereiches 391 des Ausgangssubstrates 390 auf.

An dem oberen Teil werden nachfolgend die Sensorelektroden angeformt, wohingegen der untere Teil für eine Kontaktierung des jeweiligen Sensorelements 350 verwendet wird. Dies hat den Vorteil, dass die einzelnen Sensorelemente 350 im Nutzen des Ausgangssubstrates 390 auf effektive und Platz sparende Weise angeordnet sind. Somit kann durch eine geeignete Wahl des Layouts und die Größe des Ausgangssubstrates 390 eine große Anzahl von einzelnen Sensorelementen 350 auf effektive Weise hergestellt werden kann.

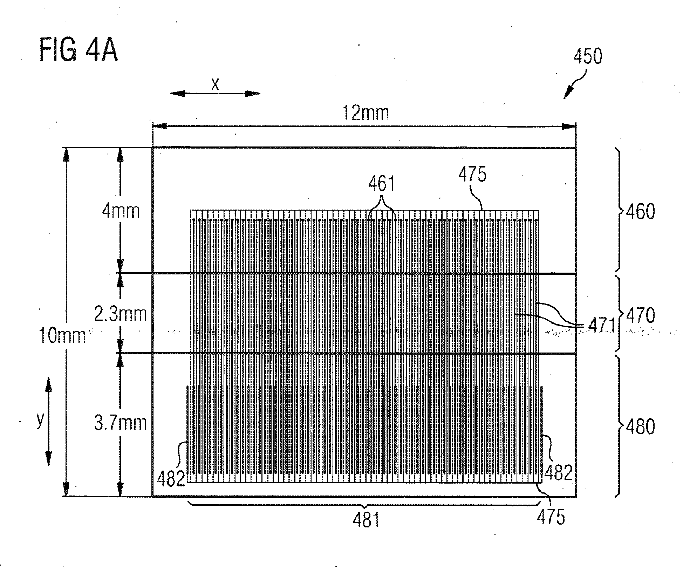

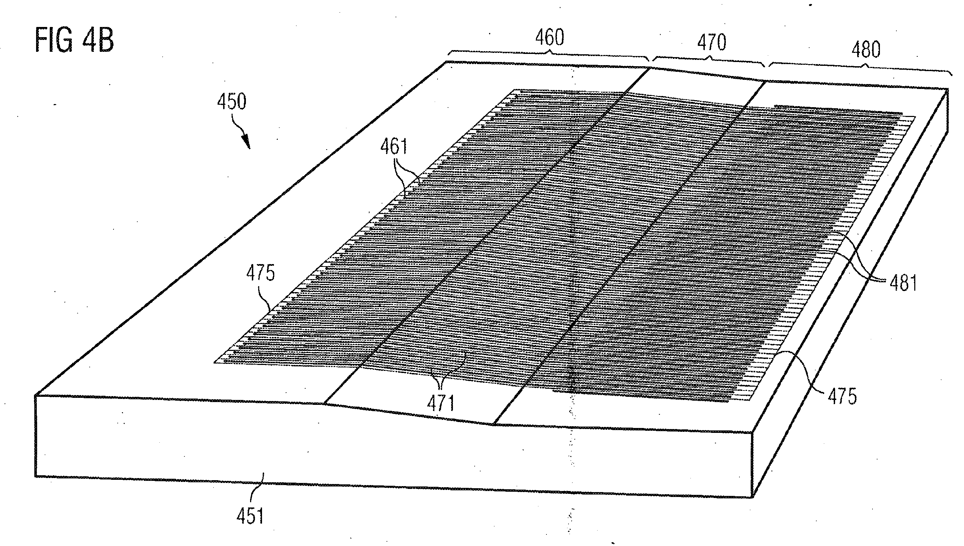

Die Figuren 4a und 4b zeigen ein Zwischenprodukt bei der Herstellung eines Mehrkanal-Sensorelementes 450. Figur 4a zeigt dieses Zwischenprodukt in einer Draufsicht, Figur 4b zeigt das Zwischenprodukt in einer perspektivischen Ansicht.

Das Zwischenprodukt weist eine erste Metallisierungsebene auf, die auf dem Sensorsubstrat 451 aufgebracht und in bekannter Weise, beispielsweise mittels Lithographie strukturiert wurde. Durch die Strukturierung werden (a) in dem erhabenen oberen Bereich 460 Sensorelektroden 461 definiert, (b) in dem vertieften unterer Bereich 480 Anschlussflächen 481 definiert und (c) in dem stufenartigen Übergangsbereich 470 Verbindungsleitungen 471 definiert. Dabei erstrecken sich die Verbindungsleitungen 471 entlang der y-Richtung auf der einen Seite bis zu den Sensorelektroden 461 und auf der anderen Seite bis zu den Anschlussflächen 481. Außerdem sind laterale Abschirmungen 475 definiert, die in der gleichen gestuften Ebene wie die Verbindungsleitungen 471 ausgebildet sind. Die lateralen Abschirmungen sind miteinander elektrisch leitend verbunden und können über Erdungs-Anschlussflächen 482 kontaktiert werden.

Figur 4c zeigt eine vergrößerte Darstellung der Sensorelektroden 461, die von den Verbindungsleitungen 471 kontaktiert und von den lateralen Abschirmungen 475 gegen elektromagnetische Strahlung abgeschirmt werden.

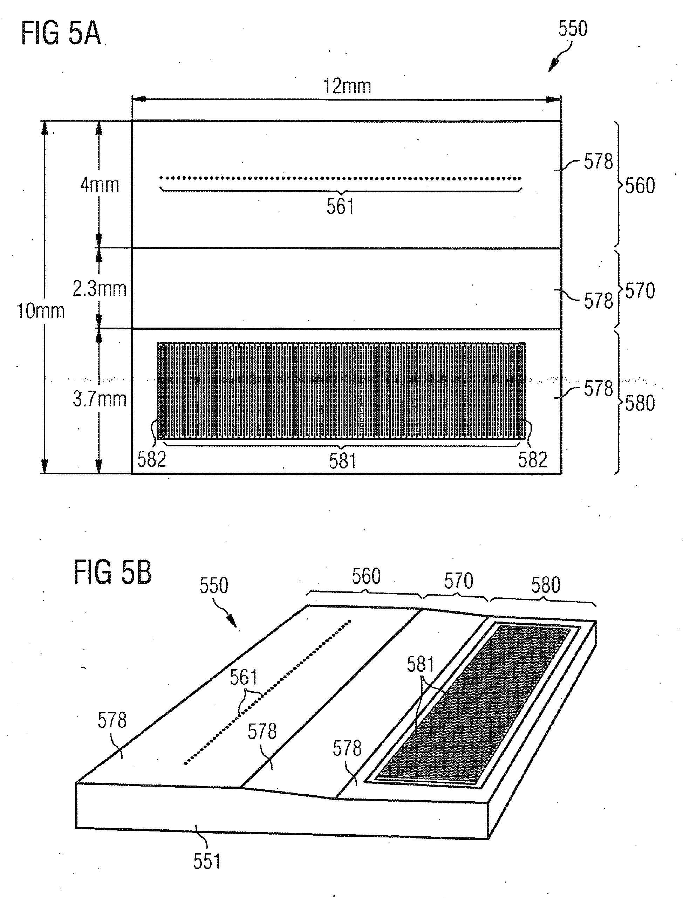

Die Figuren 5a und 5b zeigen das fertig hergestellte Mehrkanal-Sensorelement 550. Figur 5a zeigt das Mehrkanal-Sensorelement 550 in einer Draufsicht, Figur 5b zeigt das Mehrkanal-Sensorelement 550 in einer perspektivischen Ansicht.

Ausgehend von dem in den Figuren 4a und 4b dargestellten Zwischenprodukt wurde das fertige Mehrkanal-Sensorelement 550 durch folgende Verfahrensschritte hergestellt:

1. Aufbringen und Strukturierung der ersten Metallisierungslage (Aluminium)

2. Aufbringen einer Isolationsebene, beispielsweise eine Siliziumnitrid-Schicht und Strukturieren der aufgebrachten Isolationsebene, so dass die Sensorelektroden 561, die lateralen Abschirmungen und die Anschlussflächen 581 freigelegt sind.

3. Aufbringen einer weiteren Metallisierungsebene 578, beispielsweise Aluminium, und Strukturieren der weiteren Metallisierungsebene 578, beispielsweise durch Photo-Lithographie, so dass die Sensorelektroden 561 und die Anschlussflächen 581 erneut freigelegt sind.

Auf diese Weise wird durch die weitere Metallisierungsebene 578 eine vollflächige Abschirmelektrode für die Verbindungsleitungen erzeugt. Im Ergebnis stellt somit der erhabene obere Bereich des Substrates 551 ein Sensorfeld 560 dar, welches insgesamt 64 in einer Reihe angeordnete Sensorelektroden 561 aufweist, die über jeweils eine abgeschirmte Verbindungsleitung mit einer entsprechenden Anschlussfläche 581 verbunden ist. Die Anschlussflächen 581 befinden sich in dem vertieften unteren Bereich, welcher deshalb auch als Anschlussbereich 580 des Sensorelements 550 bezeichnet wird. Die Verbindungsleitungen erstrecken sich über den Übergangsbereich 570.

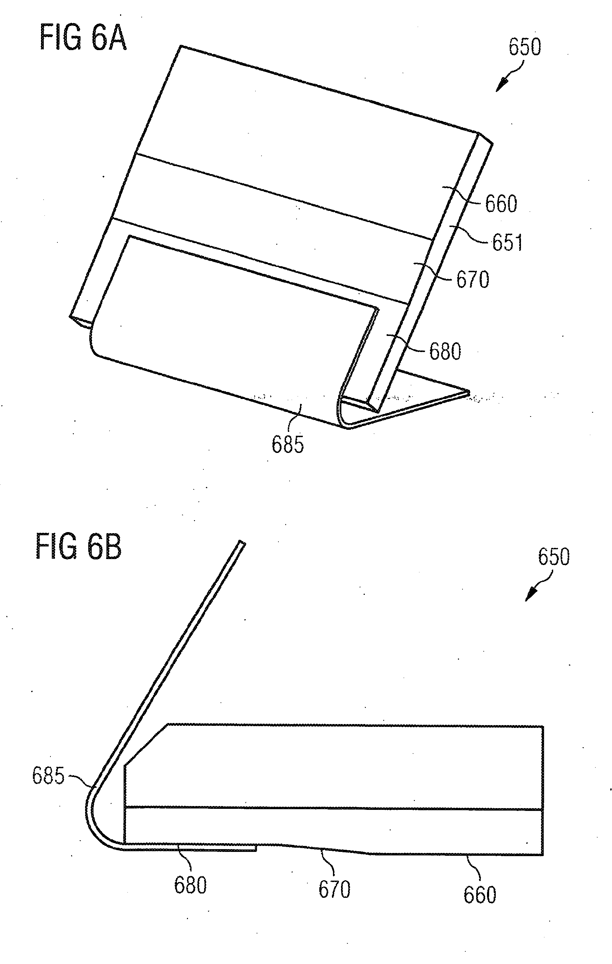

Die Figuren 6a und 6b zeigen ein mit einer flexiblen Leiterplatine 685 kontaktiertes Mehrkanal-Sensorelement 650. Figur 6a zeigt eine Draufsicht, Figur 6b zeigt eine perspektivische Ansicht des kontaktierten Mehrkanal-Sensorelements 650.

Die flexible Leiterplatine oder der Flexwire 685 ist so flach, dass selbst bei der lediglich sehr geringen Vertiefung des unteren Bereiches 680 im Vergleich zu dem oberen Bereich 660 von 200 $\mu$m die flexible Leiterplatine 685 nicht über die Sensorelektroden hinausragt. Dies bedeutet, dass die Spitzen der Sensorelektroden die am meisten erhabenen Bereiche des Mehrkanal-Sensorelements 650 darstellen.

Die flexible Leiterplatine 685 wird beispielsweise mittels eines ACF-Bondprozesses (Anisotropic Conductive Film-Bondprozesses) mit den entsprechenden Anschlussflächen kontaktiert. Selbstverständlich kann die flexible Leiterplatine 685 auch mittels herkömmlichen Wire-Bonding mit den Anschlussflächen kontaktiert werden.

Es ist möglich die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

**Bezugszeichenliste**

| | |
|---|---|
| 100 | Inspektionsvorrichtung |
| 101 | Chassis |
| 102 | Aufnahmeelement / Fixiertisch |
| 103 | Führungen (y-Führungen) |
| 104 | quer stehender Trägerarm |
| 105 | Führung (x-Führung) |
| 106 | Trägerelement |
| 110 | Auswerteeinheit |
| 130 | flächiger Träger / Flachbildschirm-Substrat |
| 131 | Leiterbahnstruktur / Leiterbahnmatrix |
| 150 | Sensorelement |
| | |
| 250 | Mehrkanal-Sensorelement |
| 251 | Substrat / Dünnglas / Wafer |
| 252 | Zentriermarkierungen |
| 260 | erhabener oberer Bereich / Sensorfeld |
| 261 | Sensorelektroden |
| 262 | plane Oberfläche |
| 270 | Übergangsbereich / Stufe |
| 280 | vertiefter unterer Bereich / Anschlussbereich |
| 281 | Anschlussflächen |
| 282 | Anschlussflächen für Erdung |
| | |
| 350 | Mehrkanal-Sensorelement |
| 390 | Ausgangssubstrat . |
| 391 | Grabenstruktur / vertiefte untere Flächenbereiche |
| 392 | erhabene obere Flächenbereiche |
| 393 | Übergangs-Zwischenbereich |

| 450 | Mehrkanal-Sensorelement |
|---|---|
| 451 | Substrat / Dünnglas / Wafer |
| 460 | erhabener oberer Bereich / Sensorfeld |
| 461 | Sensorelektroden |
| 470 | Übergangsbereich / Stufe |
| 471 | Verbindungsleitungen |
| 475 | Abschirmung |
| 480 | vertiefter unterer Bereich / Ans.chlussbereich |
| 481 | Anschlussflächen |
| 482 | Anschlussflächen für Erdung |

| 550 | Mehrkanal-Sensorelement |
|---|---|
| 551 | Substrat / Dünnglas / Wafer |
| 560 | erhabener oberer Bereich / Sensorfeld |
| 561 | Sensorelektroden |
| 570 | Übergangsbereich / Stufe |
| 578 | Metallisierungsschicht |
| 580 | vertiefter unterer Bereich / Anschlussbereich |
| 581 | Anschlussflächen |
| 582 | Anschlussflächen für Erdung |

| 650 | Mehrkanal-Sensorelement |
|---|---|
| 651 | Substrat / Dünnglas / Wafer |
| 660 | erhabener oberer Bereich / Sensorfeld |
| 670 | Übergangsbereich / Stufe |
| 680 | vertiefter unterer Bereich / Anschlussbereich |
| 685 | flexibel Leiterplatine / Flexwire |

**Patentansprüche**

1. Sensorelement zur Inspektion von einer an einem flächigen Träger (130) ausgebildeten Leiterbahnstruktur (131), zur kontaktlosen Inspektion, insbesondere von einer an einem Flachbildschirm-Substrat (130) ausgebildeten Leiterbahnmatrix (131), das Sensorelement (150, 250, 350, 450, 550, 650) aufweisend

   • ein Substrat (251, 451, 551, 651), welches mechanisch derart strukturiert ist, dass es einen erhabenen oberen Bereich (260, 360, 460, 560, 660) und einen vertieften unteren Bereich (280, 380, 480, 580, 680) aufweist, wobei der erhabene obere Bereich (260, 360, 460, 560, 660) und der vertiefte untere Bereich (280, 380, 480, 580, 680) durch einen Übergangsbereich (270, 370, 470, 570, 670) miteinander verbunden sind,
   • eine Mehrzahl von Sensorelektroden (261, 461, 561), die an dem erhabenen oberen Bereich (260, 360, 460, 560, 660) ausgebildet sind, und
   • eine Mehrzahl von Verbindungsleitungen (471) zum elektrischen Kontaktieren der Mehrzahl von Sensorelektroden (261, 461, 561), wobei
   jeder Sensorelektrode (261, 461, 561) eine Verbindungsleitung (471) zugeordnet ist, welche sich von der jeweiligen Sensorelektrode (261, 461, 561) bis hin zu dem vertieften unteren Bereich (280, 380, 480, 580, 680) erstreckt.

2. Sensorelement nach Anspruch 1, bei dem der erhabene obere Bereich (260, 360, 460, 560, 660) eine planare Oberfläche (262) aufweist.

3. Sensorelement nach einem der Ansprüche 1 bis 2, bei dem die Sensorelektroden (261, 461, 561) und/oder die Verbindungsleitungen (471) mittels Dünnschicht- und/oder Mikrostrukturierungstechnik hergestellt sind.

4. Sensorelement nach einem der Ansprüche 1 bis 3, zusätzlich aufweisend

   • eine Abschirmung (475), welche derart ausgebildet ist, dass eine elektromagnetische Abstrahlung von den Verbindungsleitungen (471) und/oder eine elektromagnetische Einstrahlung in die Verbindungsleitungen (471) zumindest reduziert ist.

**5.** Sensorelement nach einem der Ansprüche 1 bis 4, bei dem das Substrat ein Dünnglas (251, 451, 551, 651) ist.

**6.** Sensorelement nach einem der Ansprüche 1 bis 4, bei dem das Substrat ein Wafer, insbesondere ein Silizium Wafer ist.

**7.** Sensorelement nach einem der Ansprüche 1 bis 6, zusätzlich aufweisend

• eine Mehrzahl von elektrischen Anschlussflächen (281, 481, 581) zur weiteren Kontaktierung des Sensorelements (150, 250, 350, 450, 550, 650), welche Anschlussflächen (281, 481, 581) an dem vertieften unteren Bereich (280, 380, 480, 580, 680) ausgebildet sind, wobei jeweils eine Anschlussfläche (281, 481, 581) einer Sensorelektrode (261, 461, 561) zugeordnet und mit der entsprechenden Verbindungsleitung (471) elektrisch verbunden ist.

**8.** Sensorelement nach Anspruch 7, zusätzlich aufweisend

• eine flexible Leiterplatine (685), welche eine Mehrzahl von Ansteuerleitungen aufweist, wobei jeweils eine Ansteuerleitung mit einer elektrischen Anschlussfläche (281, 481, 581) verbunden ist.

**9.** Sensorelement nach Anspruch 8, bei dem die flexible Leiterplatine (685) zumindest eine flächige Schirmung aufweist.

**10.** Sensorelement nach einem der Ansprüche 1 bis 9, bei dem

- der Übergang zwischen dem Übergangsbereich (270, 370, 470, 570, 670) und dem erhabenen oberen Bereich (260, 360, 460, 560, 660) und/oder
- der Übergang zwischen dem Übergangsbereich (270, 370, 470, 570, 670) und dem vertieften unteren Bereich (280, 380, 480, 580, 680)
in einem flachen Winkel erfolgt.

**11.** Sensorelement nach einem der Ansprüche 1 bis 10, bei dem die Sensorelektroden (261, 461, 561) in einer Reihe angeordnet sind.

**12.** Vorrichtung zur Inspektion von einer an einem flächigen Träger (130) ausgebildeten Leiterbahnstruktur (131), insbesondere zur kontaktlosen Inspektion von einer an einem Flachbildschirm-Substrat (130) ausgebildeten Leiterbahnmatrix (131), die Vorrichtung aufweisend

• ein Chassis (101),
• ein Aufnahmeelement (102), welches an dem Chassis (101) angeordnet ist und welches zur Aufnahme des flächigen Trägers (130) eingerichtet ist,
• zumindest ein Sensorelement (150, 250, 350, 450, 550, 650) nach einem der Ansprüche 1 bis 10 zur Inspektion der Leiterbahnstruktur (131) und
• ein Positioniersystem (103, 104, 105, 106), welches an dem Chassis (101) angeordnet ist und welches derart mit dem Sensorelement (150, 250, 350, 450, 550, 650) und/oder mit dem Aufnahmeelement (102) gekoppelt ist, dass das Sensorelement (150, 250, 350, 450, 550, 650) relativ zu dem flächigen Träger (130) in einer Ebene parallel zu der Leiterbahnstruktur (131) positionierbar ist.

**13.** Vorrichtung nach Anspruch 12, zusätzlich aufweisend

• eine Auswerteeinheit (110), welche dem Sensorelement (150, 250, 350, 450, 550, 650) nachgeschaltet ist und welche zur Auswertung der von dem Sensorelement (150, 250, 350, 450, 550, 650) bereitgestellten Messsignale eingerichtet ist.

**14.** Verfahren zur Inspektion von einer an einem flächigen Träger (130) ausgebildeten Leiterbahnstruktur (131), insbesondere zur kontaktlosen Inspektion von einer an einem Flachbildschirm-Substrat (130) ausgebildeten Leiterbahnmatrix (131), das Verfahren aufweisend die folgenden Schritte:

• Positionieren des Sensorelements (150, 250, 350, 450, 550, 650) nach einem der Ansprüche 1 bis 10 mittels eines Positioniersystems (103, 104, 105, 106) relativ zu der Leiterbahnstruktur (131) in einem vorbestimmten Messabstand,

• Anlegen einer elektrischen Spannung zwischen den Sensorelektroden (261, 461, 561) und der Leiterbahnstruktur (131),
• Bewegen des Sensorelements (150, 250, 350, 450, 550, 650) durch eine entsprechende Ansteuerung des Positioniersystems (103, 104, 105, 106) relativ zu dem flächigen Träger (130) in einer Ebene parallel zu der Leiterbahnstruktur (131),
• Messen eines Stromflusses durch zumindest eine mit einer Sensorelektrode (261, 461, 561) verbundene Verbindungsleitung (471) und
• Detektieren eines lokalen Spannungszustands in zumindest einem Teilbereich der Leiterbahnstruktur (131).

**15.** Verfahren nach Anspruch 14, bei dem die Leiterbahnstruktur (131) durch eine rasterförmige Bewegung des Sensorelements (150, 250, 350, 450, 550, 650) abgetastet wird.

**16.** Verfahren nach einem der Ansprüche 13 bis 14, bei dem zwischen den Sensorelektroden (261, 461, 561) und der Leiterbahnstruktur (131) eine amplitudenmodulierte Spannung angelegt wird.

**17.** Herstellverfahren für zumindest ein Sensorelement (150, 250, 350, 450, 550, 650) zur Inspektion von einer an einem flächigen Träger (130) ausgebildeten Leiterbahnstruktur (131), insbesondere zur kontaktlosen Inspektion von einer an einem Flachbildschirm-Substrat (130) ausgebildeten Leiterbahnmatrix (131), das Herstellverfahren aufweisend die folgenden Schritte:

   • Erzeugen von zumindest einer Grabenstruktur (391) in einem Ausgangssubstrat (390), so dass in dem Ausgangssubstrat (390) ein erhabener oberer Flächenbereich (392) und ein vertiefter unterer Flächenbereich (391) entsteht, die über einen Übergangs-Zwischenbereich (393) miteinander verbunden sind,
   • Ausbilden der Mehrzahl von Sensorelektroden (261, 461, 561) an dem oberen Flächenbereich (392),
   • Ausbilden der Mehrzahl von Verbindungsleitungen (471), wobei jeder Sensorelektrode (261, 461, 561) eine Verbindungsleitung (471) zugeordnet ist, welche sich von der jeweiligen Sensorelektrode (261, 461, 561) bis hin zu dem vertieften unteren Flächenbereich (391) erstreckt, und
   • Vereinzeln des Ausgangssubstrates (390) derart, dass zumindest ein Sensorelement (150, 250, 350, 450, 550, 650) nach einem der Ansprüche 1 bis 10 ausgeschnitten wird, wobei

      - der erhabene obere Bereich (260, 360, 460, 560, 660) des Sensorelements (150, 250, 350, 450, 550, 650) dem erhabenen oberen Flächenbereich (392) des Ausgangssubstrates (390) zugeordnet ist,
      - der vertiefte untere Bereich (280, 380, 480, 580, 680) des Sensorelements (150, 250, 350, 450, 550, 650) dem vertieften unteren Flächenbereich (391) des Ausgangssubstrates (390) zugeordnet ist und
      - der Übergangsbereich (270, 370, 470, 570, 670) des Sensorelements (150, 250, 350, 450, 550, 650) dem Übergangs-Zwischenbereich (393) des Ausgangssubstrates zugeordnet ist.

**18.** Herstellverfahren nach Anspruch 17, zusätzlich aufweisend den Schritt

   • Ausbilden von lateralen Abschirmungen (475), die sich von dem erhabenen oberen Flächenbereich (392) bis hin zum dem vertieften unteren Flächenbereich (391) erstrecken, wobei jeweils eine laterale Abschirmung (475) neben einer Verbindungsleitung (471) angeordnet ist.

**19.** Herstellverfahren nach Anspruche 18, zusätzlich aufweisend die Schritte

   • Aufbringen einer ersten Metallisierungsschicht und Freilegen der Verbindungsleitungen,
   • Aufbringen einer Isolationsschicht,
   • Freilegen der Sensorelektroden (261, 461, 561) und der lateralen Abschirmungen (475) von der Isolationsschicht,
   • Aufbringen einer zweiten Metallisierungsschicht (578), so dass die lateralen Abschirmungen (475) und die zweite Metallisierungsschicht (578) elektrisch leitend miteinander verbunden sind, und
   • Freilegen der Sensorelektroden (261, 461, 561) von der zweiten Metallisierungsschicht (578).

**20.** Herstellverfahren nach einem der Ansprüche 17 bis 19, zusätzlich aufweisend den Schritt

   • Kontaktieren der Verbindungsleitungen (471) mittels einer flexiblen Leiterplatine (685).

**21.** Herstellverfahren nach einem der Ansprüche 17 bis 20, bei dem

eine Mehrzahl von herzustellenden Sensorelementen (150, 250, 350, 450, 550, 650) derart in dem Ausgangssubstrat (390) platziert sind, dass

- einige Sensorelemente (150, 250, 350, 450, 550, 650) zueinander benachbart in einer Reihe parallel zu einer Längsachse der Grabenstruktur (391) angeordnet sind und/oder dass
- einige Sensorelemente (150, 250, 350, 450, 550, 650) in Bezug auf eine Längsachse der Grabenstruktur (391) einander gegenüberliegend an unterschiedlichen Seiten angeordnet sind.

**Claims**

1. Sensor element for inspection of a conductor track structure (131) embodied on a planar carrier (130), for non-contact inspection, especially of a conductor track matrix (131) embodied on a flat-screen substrate (130), with said sensor element (150, 250, 350, 450, 550, 650) comprising

   • a substrate (251, 451, 551, 651), which is structured mechanically such that it has a raised upper region (260, 360, 460, 560, 660) and a lowered lower region (280, 380, 480, 580, 680), with the raised upper region (260, 360, 460, 560, 660) and the lowered lower region (280, 380, 480, 580, 680) being connected to one another by a transition region (270, 370, 470, 570, 670),
   • a plurality of sensor electrodes (261, 461, 561), which are embodied on the raised upper region (260, 360, 460, 560, 660), and
   • a plurality of connecting lines (471) for contacting the plurality of sensor electrodes (261, 461, 561), with each sensor electrode (261, 461, 561) being assigned one connecting line (471) which extends from the respective sensor electrode (261, 461, 561) through to the lowered lower region (280, 380, 480, 580, 680).

2. Sensor element as claimed in claim 1, in which the raised upper region (260, 360, 460, 560, 660) has a planar surface (262).

3. Sensor element according to one of claims 1 to 2, in which the sensor electrodes (261, 461, 561) and/or the connecting lines (471) are produced using thin-film and/or microstructuring technology.

4. Sensor element according to one of claims 1 to 3, additionally comprising

   • screening (475), which is embodied such that electromagnetic radiation emitted from the connecting lines (471) and/or electromagnetic radiation radiated into the connecting lines (471) is at least reduced.

5. Sensor element according to one of claims 1 to 4, in which the substrate is a thin glass (251, 451, 551, 651).

6. Sensor element according to one of claims 1 to 4, in which the substrate is a wafer, especially a Silicon wafer.

7. Sensor element according to one of claims 1 to 6, additionally comprising

   • a plurality of electrical connection surfaces (281, 481, 581) for further contacting of the sensor element (150, 250, 350, 450, 550, 650), with said connection surfaces (281, 481, 581) being embodied on the lower lowered region (280, 380, 480, 580, 680), with a contact surface (281, 481, 581) being assigned to a sensor electrode (261, 461, 561) in each case and with the corresponding connecting line (471) being electrically connected.

8. Sensor element according to claim 7, additionally comprising

   • a flexible printed circuit board (685) having a plurality of control lines, with a control line being connected to an electrical connecting surface (281, 481, 581) in each case.

9. Sensor element according to claim 8, in which the flexible printed circuit board (685) has at least one flat screen.

10. Sensor element according to one of claims 1 to 9, in which

    - the transition between the transition region (270, 370, 470, 570, 670) and the raised upper region (260, 360, 460, 560, 660) and/or

- the transition between the transition region (270, 370, 470, 570, 670) and the lowered lower region (280, 380, 480, 580, 680) is at an obtuse angle.

11. Sensor element according to one of claims 1 to 10, in which the sensor electrodes (261, 461, 561) are arranged in a row.

12. Device for inspection of a conductor track structure (131) embodied on a planar carrier, for non-contact inspection, especially of a conductor track matrix (131) embodied on a flat-screen substrate (130), with said device comprising

    • a chassis (101),
    • a receiving element (102), which is arranged on the chassis (101) and which is configured for receiving the planar carrier (130),
    • at least one sensor element (150, 250, 350, 450, 550, 650) according to one of claims 1 to 10 for inspection of the conductor track structure (131) and
    • a positioning system (103, 104, 105, 106), which is arranged on the chassis (101) and which is coupled to the sensor element (150, 250, 350, 450, 550, 650) and/or to the receiving element (102) such that the sensor element (150, 250, 350, 450, 550, 650) is able to be positioned relative to the planar carrier (130) in a plane in parallel to the conductor track structure (131).

13. Device according to claim 12, additionally comprising

    • an evaluation unit (110), which is connected downstream of the sensor element (150, 250, 350, 450, 550, 650) and which is configured for evaluating the measurement signals provided by the sensor element (150, 250, 350, 450, 550, 650).

14. Method for inspection of a conductor track structure (131) embodied on a planar carrier (130), especially for non-contact inspection of a conductor track matrix (131) embodied on a flat-screen substrate (130), with said method comprising the following steps:

    • Positioning of the sensor element (150, 250, 350, 450, 550, 650) according to one of claims 1 to 10 by means of a positioning system (103, 104, 105, 106) relative to the conductor track structure (131) at a predetermined measurement distance,
    • Application of an electrical voltage between the sensor electrodes (261, 461, 561) the conductor track structure (131),
    • Movement of the sensor element (150, 250, 350, 450, 550, 650) by appropriate control of the positioning system (103, 104, 105, 106) relative to the planar carrier (130) in a plane in parallel to the conductor track structure (131),
    • Measuring a current flow through at least one connecting line (471) connected to a sensor electrode (261, 461, 561) and
    • Detection of a local voltage state in at least one part region of the conductor track structure (131).

15. Method according to claim 14, in which the conductor track structure (131) is sampled by a grid-type movement of the sensor element (150, 250, 350, 450, 550, 650).

16. Method according to one of claims 13 to 14, in which an amplitude-modulated voltage is applied between the sensor electrodes (261, 461, 561) and the conductor track structure (131).

17. Fabrication method for at least one sensor element (150, 250, 350, 450, 550, 650) for inspection of a conductor track structure (131) embodied on a planar carrier (130), especially for non-contact inspection of a conductor track matrix (131) embodied on a flat-screen substrate (130), with said manufacturing method comprising the following steps:

    • Creation of at least one trench structure (391) in an starting substrate (390), so that a raised upper planar region (392) and a lowered lower planar region (391), which are connected to each other via a transitional intermediate region (393), are produced in the starting substrate (390)
    • Embodiment of the plurality of sensor electrodes (261, 461, 561) on the upper planar region (392),
    • Embodiment of the plurality of connecting lines (471), with each sensor electrode (261, 461, 561) being assigned one connecting line (471) which extends from the respective sensor electrode (261, 461, 561) through to the lowered lower region, und
• Dicing of the starting substrate (390) such that at least one sensor element (150, 250, 350, 450, 550, 650) according to one of claims 1 to 10 is cut out, with

- the raised upper region (260, 360, 460, 560, 660) of the sensor element (150, 250, 350, 450, 550, 650) being assigned to the raised upper planar region (392) of the starting substrate (390),
- the lowered lower region (280, 380, 480, 580, 680) of the sensor element (150, 250, 350, 450, 550, 650) being assigned to the lowered lower planar region (391) of the starting substrate and
- the transition region (270, 370, 470, 570, 670) of the sensor element (150, 250, 350, 450, 550, 650) being assigned to the intermediate transition region (393) of the starting substrate.

18. Production method according to claim 17, additionally comprising the step

• Embodiment of lateral screening (475) extending from the raised upper planar region (392) to the lowered lower planar region (391), with a lateral screening (475) being arranged next to a connecting line (471) in each case.

19. Manufacturing method according to claim 18, additionally comprising the steps

• Application of a first metallization layer and uncovering of the connecting lines,
• Application of an insulation layer,
• Uncovering the sensor electrodes (261, 461, 561) and the lateral screening (475) from the insulation layer,
• Application of a second metallization layer (578), so that the lateral screening (475) and the second metallization layer (578) are connected electrically-conductively to each other, und
• Uncovering sensor electrodes (261, 461, 561) from the second metallization layer (578).

20. Production method according to one of claims 17 to 19, additionally comprising the step

• Contacting of the connecting lines (471) by means of a flexible printed circuit board (685).

21. Production method according to one of claims 17 to 20, in which a plurality of sensor elements to be produced (150, 250, 350, 450, 550, 650) are placed in the starting substrate (390) such that

- a few sensor elements (150, 250, 350, 450, 550, 650) are arranged adjacent to each other in a row in parallel to a longitudinal axis of the trench structure (391) and/or that
- a few sensor elements (150, 250, 350, 450, 550, 650) are arranged in relation to a longitudinal axis of the trench structure (391) opposite one another on different sides.

**Revendications**

1. Élément de captage pour inspecter une structure de pistes conductrices (131) réalisée sur un support plan (130), et plus particulièrement pour inspecter sans contact une matrice de pistes conductrices (131) réalisée sur un substrat pour écran plat (130), l'élément de captage (150, 250, 350, 450, 550, 650) comportant :

- un substrat (251, 451, 551, 651) qui est structuré mécaniquement de manière telle qu'il présente une zone supérieure en relief (260, 360, 460, 560, 660) et une zone inférieure en creux (280, 380, 480, 580, 680), la zone supérieure en relief (260, 360, 460, 560, 660) et la zone inférieure en creux (280, 380, 480, 580, 680) étant reliées entre elles par une zone de jonction (270, 370, 470, 570, 670) ;
- une pluralité d'électrodes de captage (261, 461, 561) qui sont réalisées sur la zone supérieure en relief (260, 360, 460, 560, 660) et
- une pluralité de lignes de liaison (471) pour contacter électriquement la pluralité d'électrodes de captage (261, 461, 561), à chaque électrode de captage (261, 461, 561) étant associée une ligne de liaison (471) qui va de l'électrode de captage respective (261, 461, 561) à la zone inférieure en creux (280, 380, 480, 580, 680).

2. Élément de captage selon la revendication 1, dans lequel la zone supérieure en relief (260, 360, 460, 560, 660) présente une surface planaire (262).

**3.** Élément de captage selon l'une des revendications 1 à 2, dans lequel les électrodes de captage (261, 461, 561) et/ou les lignes de liaison (471) sont réalisées au moyen de la technique des couches minces et/ou de microstructuration.

**4.** Élément de captage selon l'une des revendications 1 à 3, comportant additionnellement un blindage (475) qui est réalisé de manière telle qu'un rayonnement électromagnétique sortant des lignes de liaison (471) et/ou un rayonnement électromagnétique entrant dans les lignes de liaison (471) sont au moins réduits.

**5.** Élément de captage selon l'une des revendications 1 à 4, dans lequel le substrat est un verre mince (251, 451, 551, 651).

**6.** Élément de captage selon l'une des revendications 1 à 4, dans lequel le substrat est une tranche, et plus particulièrement une tranche de silicium.

**7.** Élément de captage selon l'une des revendications 1 à 6, comportant additionnellement une pluralité de faces de raccordement électrique (281, 481, 581) pour le contactage supplémentaire de l'élément de captage (150, 250, 350, 450, 550, 650), lesquelles faces de raccordement (281, 481, 581) sont réalisées sur la zone inférieure en creux (280, 380, 480, 580, 680), respectivement une face de raccordement (281, 481, 581) étant associée à une électrode de captage (261, 461, 561) et étant reliée électriquement à la ligne de liaison correspondante (471).

**8.** Élément de captage selon la revendication 7, comportant additionnellement une carte de circuits imprimés souple (685) qui présente une pluralité de lignes de commande, respectivement une ligne de commande étant reliée à une face de raccordement électrique (281, 481, 581).

**9.** Élément de captage selon la revendication 8, dans lequel la carte de circuits imprimés souple (685) comporte au moins un blindage plan.

**10.** Élément de captage selon l'une des revendications 1 à 9, dans lequel

- le passage entre la zone de jonction (270, 370, 470, 570, 670) et la zone supérieure en relief (260, 360, 460, 560, 660) et/ou
- le passage entre la zone de jonction (270, 370, 470, 570, 670) et la zone inférieure en creux (280, 380, 480, 580, 680) se font à angle plat.

**11.** Élément de captage selon l'une des revendications 1 à 10, dans lequel les électrodes de captage (261, 461, 561) sont agencées en série.

**12.** Dispositif pour inspecter une structure de pistes conductrices (131) réalisée sur un support plan (130), et plus particulièrement pour inspecter sans contact une matrice de pistes conductrices (131) réalisée sur un substrat pour écran plat (130), le dispositif comportant

- un châssis (101) ;
- un élément de logement (102) qui est disposé sur le châssis (101) et qui est aménagé pour loger le support plan (130) ;
- au moins un élément de captage (150, 250, 350, 450, 550, 650) selon l'une des revendications 1 à 10 pour l'inspection de la structure de pistes conductrices (131) ; et
- un système de positionnement (103, 104, 105, 106) qui est disposé sur le châssis (101) et qui est couplé de manière telle à l'élément de captage (150, 250, 350, 450, 550, 650) et/ou à l'élément de logement (102) que l'élément de captage (150, 250, 350, 450, 550, 650) peut être positionné relativement au support plan (130) dans un plan parallèle à la structure de pistes conductrices (131).

**13.** Dispositif selon la revendication 12, comportant additionnellement une unité d'évaluation (110) qui est montée en aval de l'élément de captage (150, 250, 350, 450, 550, 650) et qui est aménagée pour évaluer les signaux de mesure fournis par l'élément de captage (150, 250, 350, 450, 550, 650).

**14.** Procédé pour inspecter une structure de pistes conductrices (131) réalisée sur un support plan (130), et plus particulièrement pour inspecter sans contact une matrice de pistes conductrices (131) réalisée sur un substrat pour écran plat (130), le procédé comportant les étapes suivantes :

- positionnement de l'élément de captage (150, 250, 350, 450, 550, 650) selon l'une des revendications 1 à 10 au moyen d'un système de positionnement (103, 104, 105, 106) relativement à la structure de pistes conductrices (131) à une distance de mesure prédéfinie ;
- application d'une tension électrique entre les électrodes de captage (261, 461, 561) et la structure de pistes conductrices (131) ;
- déplacement de l'élément de captage (150, 250, 350, 450, 550, 650) par une commande correspondante du système de positionnement (103, 104, 105, 106) relativement au support plan (130) dans un plan parallèle à la structure de pistes conductrices (131) ;
- mesure d'un flux de courant par au moins une ligne de liaison (471) reliée à une électrode de captage (261, 461, 561) et
- détection d'un état de tension local dans au moins une zone partielle de la structure de pistes conductrices (131).

**15.** Procédé selon la revendication 14, dans lequel la structure de pistes conductrices (131) est balayée par un mouvement de grille de l'élément de captage (150, 250, 350, 450, 550, 650).

**16.** Procédé selon l'une des revendications 13 à 14, dans lequel une tension modulée en amplitude est appliquée entre les électrodes de captage (261, 461, 561) et la structure de pistes conductrices (131).

**17.** Procédé de fabrication d'au moins un élément de captage (150, 250, 350, 450, 550, 650) pour inspecter une structure de pistes conductrices (131) réalisée sur un support plan (130), et plus particulièrement pour inspecter sans contact une matrice de pistes conductrices (131) réalisée sur un substrat pour écran plat (130), le procédé de fabrication comportant les étapes suivantes :

- création d'au moins une structure de tranchées (391) dans un substrat de départ (390) de sorte qu'il se forme dans le substrat de départ (390) une zone de surface supérieure en relief (392) et une zone de surface inférieure en creux (391) qui sont reliées entre elles par l'intermédiaire d'une zone intermédiaire de jonction (393) ;
- formation de la pluralité d'électrodes de captage (261, 461, 561) sur la zone de surface supérieure (392) ;
- formation de la pluralité de lignes de liaison (471), à chaque électrode de captage (261, 461, 561) étant associée une ligne de liaison (471) qui va de l'électrode de captage respective (261, 461, 561) à la zone de surface inférieure en creux (391) et
- individualisation du substrat de départ (390) de manière à découper au moins un élément de captage (150, 250, 350, 450, 550, 650) selon l'une des revendications 1 à 10,

  ■ la zone supérieure en relief (260, 360, 460, 560, 660) de l'élément de captage (150, 250, 350, 450, 550, 650) étant associée à la zone de surface supérieure en relief (392) du substrat de départ (390) ;
  ■ la zone inférieure en creux (280, 380, 480, 580, 680) de l'élément de captage (150, 250, 350, 450, 550, 650) étant associée à la zone de surface inférieure en creux (391) du substrat de départ (390) et
  ■ la zone de jonction (270, 370, 470, 570, 670) de l'élément de captage (150, 250, 350, 450, 550, 650) étant associée à la zone intermédiaire de jonction (393) du substrat de départ.

**18.** Procédé de fabrication selon la revendication 17, comportant additionnellement l'étape de formation de blindages latéraux (475) qui vont de la zone de surface supérieure en relief (392) à la zone de surface inférieure en creux (391), respectivement un blindage latéral (475) étant disposé à côté d'une ligne de liaison (471).

**19.** Procédé de fabrication selon la revendication 18, comportant additionnellement les étapes suivantes :

- application d'une première couche de métallisation et dégagement des lignes de liaison ;
- application d'une couche isolante ;
- dégagement des électrodes de captage (261, 461, 561) et des blindages latéraux (475) de la couche d'isolation ;
- application d'une deuxième couche de métallisation (578) de sorte que les blindages latéraux (475) et la deuxième couche de métallisation (578) sont reliés entre eux de manière électriquement conductrice ; et
- dégagement des électrodes de captage (261, 461, 561) de la deuxième couche de métallisation (578).

**20.** Procédé de fabrication selon l'une des revendications 17 à 19, comportant additionnellement l'étape de contactage des lignes de liaison (471) au moyen d'une carte de circuits imprimés souple (685).

**21.** Procédé de fabrication selon l'une des revendications 17 à 20, dans lequel une pluralité d'éléments de captage à fabriquer (150, 250, 350, 450, 550, 650) sont placés de manière telle dans le substrat de départ (390) que :

- quelques éléments de captage (150, 250, 350, 450, 550, 650) sont disposés de manière à être voisins les uns des autres dans une série parallèlement à un axe longitudinal de la structure de tranchées (391) ; et/ou
- quelques éléments de captage (150, 250, 350, 450, 550, 650) sont disposés de manière à se faire face sur différents côtés par rapport à un axe longitudinal de la structure de tranchées (391).

FIG 1

## FIG 2A

## FIG 2B

## FIG 3A

391
390
392
393
392
391

y

x

## FIG 3B

12.95    12.3    12.3    12.3    12.3
8.3    8.3    8.3    12.95

z

390

y

12.3mm
~2.3mm
391                          393
392
390                                      200μm
5°    ~7.7mm    5°

## FIG 3C

350                              390
392                              391
393
392                              391
392

350                              y

x

## FIG 4A

FIG 4B

## FIG 4C

## FIG 5A

## FIG 5B

## FIG 6A

650

660
651
670
680

685

## FIG 6B

650

685

680        670        660

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5974869 A
- US 20010028256 A

- FR 2792076